# EUROPÄISCHE PATENTSCHRIFT

(11) **EP 2 927 954 B1**
(45) Veröffentlichungstag und Bekanntmachung des Hinweises auf die Patenterteilung: **09.06.2021**
(21) Anmeldenummer: 14163131.7
(22) Anmeldetag: 02.04.2014
(51) Int. Cl.: H01L 23/00, H01L 23/40, H01L 25/065, H01L 23/31, H05K 7/02, H01L 25/11

(54) **Befestigungssystem für ein Leistungsmodul**
Fastening system for a power module
Système de fixation pour un module de puissance

(43) Veröffentlichungstag der Anmeldung: 07.10.2015
(73) Patentinhaber: Brusa Elektronik AG, 9466 Sennwald (CH)
(72) Erfinder: Berkmann, Martin, 6866 Andelsbuch (AT); Stengert, Katja, 9464 Lienz (CH)
(74) Vertreter: Rösler, Frank

(56) Entgegenhaltungen:
- EP-A2- 0 785 575
- EP-A2- 1 536 467
- FR-A1- 2 931 523
- JP-A- S5 999 743
- JP-A- 2004 087 552
- JP-A- 2011 035 265
- US-A1- 2009 168 358
- US-A1- 2010 127 391

## Beschreibung

Die Erfindung betrifft ein Anpresselement für ein Leistungsmodul nach dem Oberbegriff des Anspruchs 1. Weiters betrifft die Erfindung ein derartiges Befestigungssystem, nach dem Oberbegriff des Anspruchs 5.

Ein Leistungsmodul ist eine spezielle Art von integriertem Schaltkreis (IC), bei dem zwecks Steuerung von grossen Strömen und Spannungen entsprechend grosse Gehäuse, Transistoren und Dioden eingesetzt werden. Es besteht typischerweise aus einem Formkörper mit einer im Wesentlichen ebenen Fläche zur Anlage an eine Tragstruktur und einer Mehrzahl von aus dem Formkörper herausragenden Kontaktpins. Solche Leistungsmodule werden wegen der oftmals hohen Wärmeentwicklung typischerweise derart verbaut, dass die Wärme über eine beispielsweise ganzflächig metallisierte Anlagefläche und die Anschlüsse des Powersubstrates sowie je nach Bauform und Einsatzort gegebenenfalls über eine thermisch leitfähige Zwischenschicht an die Tragstruktur und/oder an einen Kühlkörper abgegeben wird. Mit Folien oder wärmeleitenden Pasten können kleinste Unebenheiten zwischen Leistungsmodul und Tragstruktur bzw. Kühlkörper ausgeglichen bzw. der Wärmewiderstand reduziert werden.

Wie bei herkömmlichen ICs werden die Halbleiter-Chips in Leistungsmodulen mit Bonddrähten verdrahtet. In herkömmlichen Leistungsmodulen sind die Halbleiter-Chips und Bonddrähte mit einer weichen Silikonmasse eingegossen (molded). Technisch fortschrittlichere, als Moldmodul aufgebaute Leistungsmodule sind wie herkömmliche ICs hartvergossen. Aufgrund des Herstellungsprozesses ist die Rückseite der Moldmodule nun aber nicht perfekt eben, sondern ist von der Mitte her nach aussen etwas gekrümmt. Diese Krümmung kann durch Folien, Pasten oder dergleichen nicht mehr ausgeglichen werden, so dass die Leistungsmodule vielfach durch Anpresselemente gegen die Tragstruktur bzw. den Kühlkörper gepresst werden. Diese Anpresselemente sind typischerweise starre, meist längliche Platten, wobei zur Verteilung des Drucks und Vermeidung lokaler Druckspitzen Schaumstoffmatten zwischen Anpresselement und Leistungsmodul eingelegt werden müssen, was den Aufwand für die Bauteile als auch die Fertigung erheblich erhöht.

So offenbart beispielsweise die FR2931523A1 eine Klammer zum Andrücken von elektronischen Bauteilen, welche einen Befestigungsabschnitt aufweist, der sich neben den - insbesondere zwischen zwei - zu befestigenden Bauteilen befindet. Von diesem seitlichen Befestigungsbereich ausgehende Laschen wirken auf die zentralen Bereiche der Bauteile ein, um diese an die Unterlage bzw. deren Sitz anzudrücken. Auch die EP0785575A2 offenbart ein derartiges Befestigungselement, dessen Befestigungsabschnitt einseitig neben dem elektronischen Bauteil liegt und in befestigter Lage unmittelbar auf der Tragstruktur anliegt. Nur eine längliche Lasche reicht zu einem zentralen Bereich des Bauteils und übt eine Anpresskraft allein auf dessen zentralen Bereich aus. In ähnlicher Weise offenbart auch die US2009/0168358A1 ein Anpresselement mit einer über den zu befestigenden Bauteil auskragende Lasche. Das Endstück dieser Lasche ist mit einer Tellerfeder versehen, die wieder zentral auf den elektronischen Bauteil einwirkt.

EP1536467 offenbart einen Halter und Wärmeleiter für ein Elektronikbauteil.

In der JP2011035265A ist eine Variante für ein Anpresselement offenbart, dessen Befestigungselement durch den zu befestigenden elektronischen Bauteil hindurchgeführt ist. Das Anpresselement in Form einer kreisringförmigen Tellerfeder erfasst konstruktionsbedingt nicht den überwiegenden Abschnitt der Randbereiche.

Die US2010012739A1 schliesslich offenbart ein Befestigungselement in Form eines den elektronischen Bauteil übergreifenden Bandes mit auf die Tragstruktur hin abgeknickten Befestigungsabschnitten. Diese beiderseits des Bauteils liegenden Abschnitte liegen in befestigtem Zustand auf der Tragstruktur direkt auf. Die genaue Position der Krafteinleitung in den Bauteil und damit dessen Anpressung auf die Unterlage ist nicht definiert.

Aufgabe der vorliegenden Erfindung ist es somit, ein Anpresselement für ein oder mehrere Leistungsmodule anzugeben, das unter Vermeidung der oben genannten Nachteile die sichere, einfache und betreffend des Wärmeübergangs vom Leistungsmodul auf die Tragestruktur optimierte Befestigung gewährleistet. Eine weitere Aufgabe der Erfindung ist ein Befestigungssystem unter Verwendung dieses optimierten Anpresselementes.

Die erste Aufgabe wird durch die Merkmale des unabhängigen Anspruchs 1 gelöst. Die weitere Aufgabe wird durch die Merkmale des unabhängigen Anspruchs 5 gelöst. Vorteilhafte Weiterbildungen sind in den Figuren und in den abhängigen Patentansprüchen dargelegt.

Gemäss der Erfindung gehen am Anpresselement für ein Leistungsmodul äussere Abschnitte zungen- oder laschenförmig von vorzugsweise einem zentralen Bereich des Anpresslementes aus, deren äussere Randbereiche in befestigter Stellung von Leistungsmodul und Anpresselement elastisch auf Randbereiche des Leistungsmoduls einwirken. Mittels dieser Randbereiche wird das Leistungsmodul mit einer Anpresskraft beaufschlagt. Damit wird das Leistungsmodul ausschliesslich an den am stärksten aus der idealen Ebene des Gehäuses heraus gekrümmten Abschnitten, nämlich den Eckbereichen, mit der Niederhalte- bzw. Anpresskraft beaufschlagt. In den übrigen Bereichen bleibt das Modul frei und wird durch das Anpresselement nicht berührt, so dass keinerlei schützende Zwischenstücke, Matten od. dgl. vorgesehen sein müssen. Auch bietet das Anpresselement eine ausreichende Vorspannkraft auf das Gehäuse des Moduls, so dass auch aus dieser Hinsicht Matten zum Druckausgleich -wie bei starren Platten als Anpresselemente - nicht benötigt werden. Allein durch die Einwirkung auf die hochgekrümmten Ecken wird das Gehäuse des Leistungs- oder Moldmoduls zwischen dessen Tragstruktur und dem Anpresselement in eine ebene Form gebracht, in welcher es gleichmässig über die gesamte Fläche an der Tragstruktur aufliegt. So ist es einerseits gegen unerwünschte Bewegungen gesichert und andererseits ist der Wärmeübergang auf die Tragstruktur und/oder einen Kühlkörper über die maximal zur Verfügung stehende Fläche sichergestellt.

Eine weitere Ausführungsform eines erfindungsgemässen Anpresselementes ist dadurch gekennzeichnet, dass die am Anpresselement ausgeformten Abschnitte als sich entlang eines Randbereiches des Leistungsmoduls erstreckenden Randstreifen ausgebildet sind. Vorzugsweise liegen diese Randstreifen an zwei gegenüberliegenden Seiten des Anpresselementes, um damit eine gleichmässig verteilte Krafteinleitung in den Formkörper des Leistungsmoduls zu erzielen. Die Abschnitte des Anpresselementes liegen alternativ oder zusätzlich zum vorstehenden Merkmal vorzugsweise in einem Randbereich mit Kontaktpins. Dadurch werden diese Kontaktpins sicher, unverschiebbar und in einer genau definierten Position gehalten.

Gemäss einer weiteren bevorzugten Ausführungsform ist vorgesehen, dass Befestigungsabschnitte als das Leistungsmodul überragende Laschen mit Bohrungen zur Aufnahme von Verbindungselementen, vorzugsweise in Form von Schrauben, am Anpresselement ausgebildet sind. Diese Art der Befestigung ist einfach in der Fertigung, bei der Montage und auch der Demontage, etwa bei notwendigem Austausch des Leistungsmoduls.

Zumindest die mit dem Leistungsmodul in Kontakt kommenden Randbereiche einer weiteren erfindungsgemässen Ausführungsform des Anpresselementes sind auf das Leistungsmodul hin gekrümmt. Dadurch kann bei Bedarf die erzielbare Anpresskraft gesteigert werden.

Eine vorteilhafte Ausführungsform des erfindungsgemässen Befestigungssystems in einer Variante für mehrere Leistungsmodule ist dadurch gekennzeichnet, dass das Anpresselement eine Länge aufweist um mehrere Leistungsmodule zu übergreifen, wobei zumindest ein Befestigungsabschnitt in einem Bereich des Anpresselementes zwischen zwei benachbarten Leistungsmodulen ausgebildet ist. Damit ist auch für eine Anordnung mehrerer, in einer Reihe hintereinander angeordneter Leistungsmodule die vorteilhafte sichere und die Leistungsmodule in ebene Form pressende Anbringung an einer Tragstruktur und/oder einem Kühlkörper möglich. Durch die Befestigung und damit auch die Möglichkeit der Einbringung der Anpresskraft zwischen zwei benachbarten Leistungsmodulen kann für alle Leistungsmodule die gleiche Anpresswirkung gewährleistet werden, ohne dass einzelne Leistungsmodule zu stark beaufschlagt und damit vielleicht beschädigt werden können. Andererseits wird dadurch auch eine zu geringe Anpresswirkung auf einzelne, insbesondere die in der Mitte der Reihe liegenden Leistungsmodule vermieden.

Ein Befestigungssystem für eine Leistungsmodul ist gemäss der vorliegenden Erfindung mit einem Anpresselement entsprechend einem der vorhergehenden Absätze ausgebildet, wobei die äusseren Abschnitte und deren äussere Randbereiche in befestigter Stellung von Leistungsmodul und Anpresselement elastisch auf Randbereiche des Leistungsmoduls einwirken und diese Randbereiche mit einer Anpresskraft beaufschlagen. Damit kann die Anpresswirkung und Anpressrichtung bis zu einem gewissen Grad von der Befestigung des Anpresselementes entkoppelt werden und es können vor allem die Angriffspunkte der Anpresskraft unabhängig von den Befestigungspunkten gewählt werden.

Bevorzugt sind dabei Befestigungsabschnitte für je zumindest ein Verbindungselement an zwei gegenüberliegenden Randbereichen des Anpresselementes vorgesehen, die in befestigter Stellung von Leistungsmodul und Anpresselement im Bereich eines kontaktpinfreien Randbereiches des Leistungsmoduls zu liegen kommen.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung beschrieben sind. Dabei können die in den Ansprüchen und in der Beschreibung erwähnten Merkmale jeweils einzeln für sich oder in beliebiger Kombination erfindungswesentlich sein.

Die Bezugszeichenliste ist Bestandteil der Offenbarung. Die Figuren werden zusammenhängend und übergreifend beschrieben. Gleiche Bezugszeichen bedeuten gleiche Bauteile, Bezugszeichen mit unterschiedlichen Indices geben funktionsgleiche oder ähnliche Bauteile an.

Es zeigen dabei:
- Fig. 1: ein Leistungsmodul zur Verwendung mit dem erfindungsgemässen Befestigungssystem in perspektivischer Ansicht,
- Fig. 2: ein Anpresselement in einer bevorzugten Ausführungsform zur Verwendung mit dem erfindungsgemässen Befestigungssystem in perspektivischer Ansicht,
- Fig. 3: das Leistungsmodul der Fig. 1 und das Anpresselement der Fig. 2 in zusammenwirkender Anordnung im Rahmen des erfindungsgemässen Befestigungssystems,
- Fig. 4: eine Seitenansicht der Anordnung der Fig. 3 aus einer Richtung parallel zu den Randbereichen mit den Kontaktpins, und

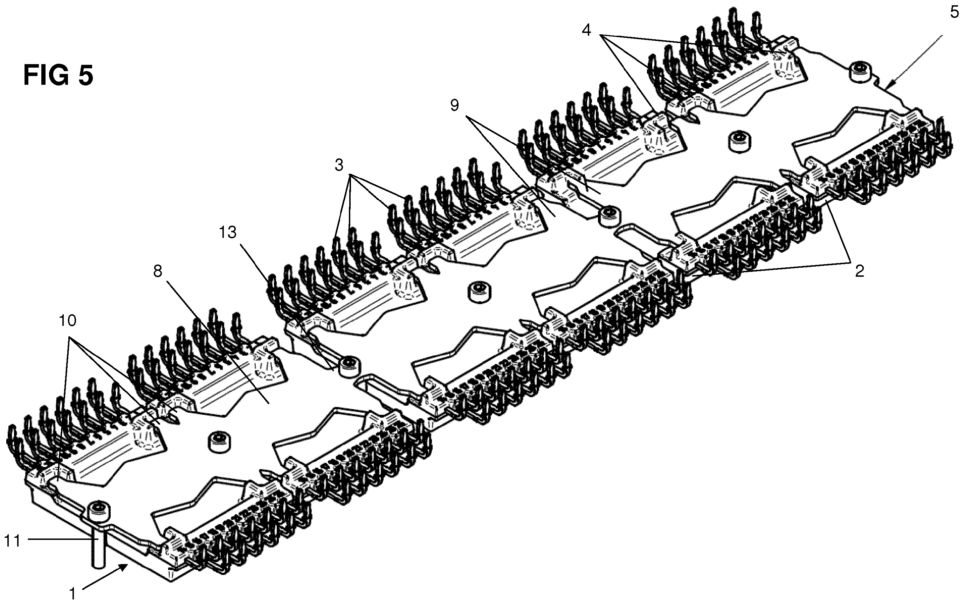

- Fig. 5: eine perspektivische Ansicht einer Anordnung von mehreren Leistungsmodulen mit einem gemeinsamen erfindungsgemässen Anpresselement.

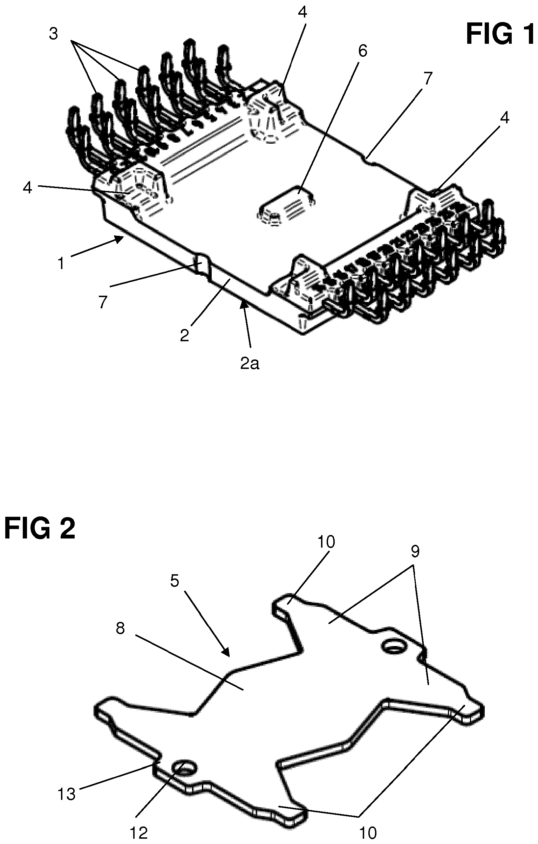

Fig. 1 zeigt ein Leistungsmodul 1 mit einem Formkörper 2 und von der im Formkörper 2 typischerweise vergossenen Schaltung nach aussen führenden und vorzugsweise gleich grossen Kontaktpins 3. Für grosse Ströme können zwei oder mehrere Kontaktpins 3 auch parallel geschaltet werden, oder es können Kontaktpins 3 ausgelassen werden zur Erhöhung der Luft- und Kriechstrecken. Im Inneren des Formkörpers 2 sind die Halbleiter-Chips mit Bonddrähten verdrahtet und entweder mit einer weichen Silikonmasse vergossen oder bei technisch fortschrittlicheren, als Moldmodule ausgebildeten Leistungsmodulen 1 hartvergossen. Durch den harten Verguss können die Bonddrähte nicht mehr wackeln, somit gibt es keine Ermüdungsbrüche und das Vibrationsproblem ist beseitigt.

Die Kontaktpins 3 sind vorzugsweise als Einpresspins ausgebildet, bei welchen keinerlei Zinndurchstiegsprobleme wie bei hochbestromten, bleifrei gelöteten Pins auftreten. Die Kontaktpins 3 liegen vorzugsweise in zwei versetzten Reihen, um trotz der kompakten Bauweise (Pinabstand z. B. nur 3 mm) ausreichende Abstände realisieren zu können. So kann das Leistungsmodul 1 auch für höhere Spannungen eingesetzt werden (beispielsweise bis zu 1000VDC)

Derartige Leistungsmodule weisen eine deutlich gesteigerte Zuverlässigkeit sowie Lebensdauer gegenüber herkömmlichen Leistungsmodulen auf. Aufgrund der reduzierten Komplexität des inneren Aufbaus und Herstellprozesses sind derartige Leistungsmodule auch einfacher und günstiger zu fertigen. Vorzugsweise ist dabei die Bauform des Formkörpers 2 und die Anordnung der Kontaktpins 3 für alle Varianten des Leistungsmoduls 1 gleich, so dass eine Art "generisches Gehäuse" geschaffen ist. Bauform und Lage der Anschlüsse ist immer gleich und das Innenleben kann je nach Aufgabenstellung und Einsatzzweck angepasst werden.

Ein spezielles Problem bei den bislang bekannten Leistungsmodulen ist deren Befestigung, die fast jedes Mal individuell gelöst werden musste. Hier greift das erfindungsgemässe Befestigungssystem und bietet eine neue, vorteilhafte Lösung.

Wie in Fig. 1 zu erkennen ist, ist ein mit dem erfindungsgemässen Befestigungssystem zu verwendendes Leistungsmodul 1 mit einem Formkörper 2 versehen, der mit einer im Wesentlichen ebenen Anlagefläche 2a zur Anlage an eine Tragstruktur ausgebildet ist. An der der Tragestruktur - oder auch an einem Kühlkörper oder dergleichen - gegenüberliegenden Seite des Formkörpers 2 sind Aufnahmen 4 für Abschnitte eines Anpresselementes 5 (siehe Fig. 2) typischerweise im Randbereich des Formkörpers 2 vorgesehen. Bei Leistungsmodulen 1 mit eckigem Formkörper 2 - wie jenem in Fig. 1 - sind diese Aufnahmen 4 vorzugsweise an zumindest symmetrisch um das Zentrum des Formkörpers 2 verteilten Ecken des Leistungsmoduls 1 angeordnet.

Die Aufnahmen 4 sind dabei vorzugsweise erhöht in Bezug auf den zentralen Bereich des Formkörpers 2 angeordnet. Gegebenenfalls ist vorzugsweise im zentralen Bereich des Formkörpers eine weitere Erhöhung 6 angeordnet. Diese erreicht dabei in Bezug auf den zentralen Bereich des Formkörpers 2 vorzugsweise maximal die Höhe der Aufnahmen 4. Um die Symmetrie der Krafteinleitung durch das Anpresselement 5 in den Formkörper 2 möglichst nicht negativ zu beeinflussen, ist typischerweise die weitere Erhöhung 5 zentral am Formkörper 2 angeordnet.

Schliesslich kann der Formkörper 2 noch mit zumindest einer Ausnehmung 7 am äusseren kontaktpinfreien Randbereich versehen sein, beispielsweise in Form einer halbrunden, nach aussen hin offenen Nut oder Ausfräsung. Vorzugsweise ebenfalls im kontaktpinfreien Randbereich des Formkörpers 2, allenfalls, wenn das die Anordnung der Halbleiter-Chips im Inneren des Formkörpers 2 gestattet, könnte auch eine Durchgangsöffnung mit vorzugsweise kreisförmigem Querschnitt zur Hindurchführung von vorzugsweise Befestigungselementen oder dergleichen vorhanden sein.

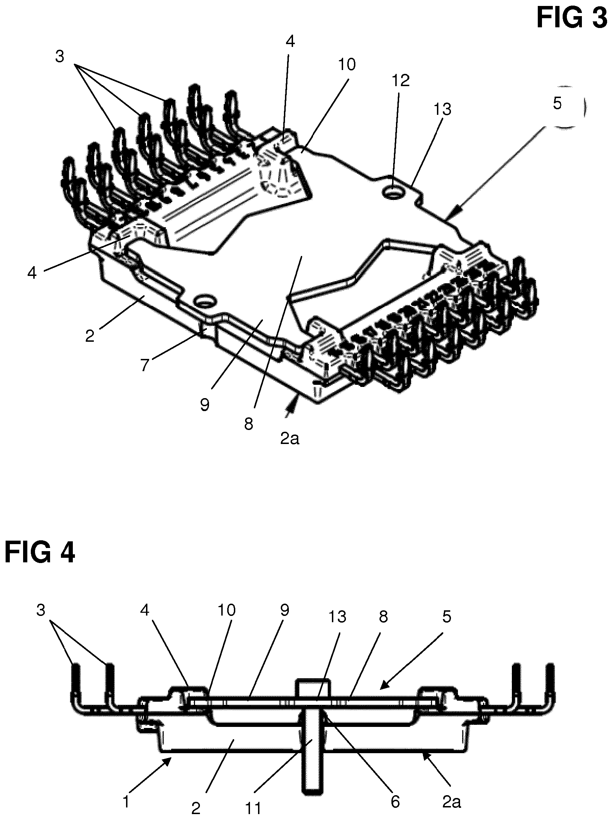

Fig. 2 zeigt ein erfindungsgemässes Anpresselement 5 zur Verwendung in einem Befestigungssystem für Leistungsmodule 1 wie oben beschrieben. Es weist von einem zentralen Bereich 8 ausgehende äussere Abschnitte 9 auf. Diese Abschnitte 9 gehen in äussere Randbereiche 10 über, die in einer derartigen geometrischen Anordnung - vorzugsweise spiegel- oder punktsymmetrisch um eine Achse bzw. das Zentrum des Anpresselementes 5 - vorliegen, dass sie bei Auflegen des Anpresselementes 5 auf das Leistungsmodul 1 in die Aufnahmen 4 des Formkörpers 2 zu liegen kommen. Wenn dann das Anpresselement 5 durch geeignete Verbindungselemente 11 (siehe Fig. 4), wie beispielsweise Schrauben, in Richtung auf das Leistungsmodul 1 bzw. der darunter liegenden Tragstruktur hin mit einer Kraft beaufschlagt wird, werden die Randbereiche 10 gegen die Aufnahmen 4 gepresst und bewirken eine durch die Aufnahmen 4 auf die Tragstruktur hin gerichtete Anpresskraft auf das Leistungsmodul 1. Die Krafteinwirkung erfolgt dabei in elastischer Weise. Durch die genaue Form und Ausrichtung der nach aussen weisenden Abschnitte 9 und der äusseren Randbereiche 10 des Anpresselementes 5 können die Anpresswirkung und die Anpressrichtung bis zu einem gewissen Grad von der Befestigung des Anpresselementes 5 entkoppelt und die Angriffspunkte der Anpresskraft unabhängig von den Befestigungspunkten gewählt werden.

Zur Befestigung des Anpresselementes 5 an der Tragstruktur oder einem Kühlkörper oder dergleichen mittels der bereits genannten Verbindungselemente 11 sind an den Rändern des Anpresselementes 5, vorzugsweise jenen Rändern, die parallel zu den kontaktpinfreien Rändern der Leistungsmoduls 1 verlaufen, Ausnehmungen zum Einsetzen des Verbindungselementes 11 oder vorzugsweise Durchgangsöffnungen 12 mit vorzugsweise kreisförmigem Querschnitt angeordnet. Vorzugsweise gehen dafür Befestigungsabschnitte 13, vorteilhafterweise in Form von Laschen oder Zungen, vom zentralen Bereich 8 des Anpresselementes 5 aus, vorzugsweise für je zumindest ein Verbindungselement 11 an den zwei gegenüberliegenden Randbereichen des Anpresselementes 5. Vorteilhafterweise sind die Durchgangsöffnungen 12 des Anpresselements 5 in diesen Befestigungsabschnitten 13 derart positioniert, dass das Verbindungselement 11 durch die Ausnehmung 7 des Formkörpers 2 verläuft.

Die Wirkungsweise des erfindungsgemässen Befestigungssystems ist aus den Fig. 3 und 4 einfach zu entnehmen. Die äusseren Abschnitte 10 des Anpresselementes 5, das den Formkörper 2 des Leistungsmoduls 1 überdeckend auf dessen Oberseite aufgelegt ist, greifen in die Aufnahmen 4 des Formkörpers 2 ein. Diese äusseren Abschnitte 10 sind dort vorzugsweise zumindest teilweise formschlüssig aufgenommen und wirken nach Befestigung des Anpresselementes 5 elastisch auf die Randbereiche des Leistungsmoduls 1 mit den Aufnahmen 4 ein. Das Anpresselement 5 wirkt derart ausschliesslich an den am stärksten aus der idealen Ebene bzw. der Kontakteebene mit der Tragstruktur oder einem Kühlkörper heraus gekrümmten Abschnitten des Formkörpers 2 ein, nämlich an den Eckbereichen. Diese Bereiche des Leistungsmoduls 1 werden lokal begrenzt mit der Niederhalte- bzw. Anpresskraft beaufschlagt. Derart ist es möglich, den Formkörper 2 in eine ebene Form zu drücken, in der die Unterseite des Formkörpers 2 gleichmässig über die gesamte Fläche der Unterseite an der Tragstruktur aufliegt.

Für eine Anordnung von mehreren Leistungsmodulen 1, die in einer geraden Reihe hintereinander, mit den Reihen der Kontaktpins 3 ebenfalls in gerader Linie hintereinander, vorliegen, kann ein mehrere oder sogar alle aufgereihten Leistungsmodule 1 übergreifendes Anpresselement 5a vorgesehen sein. Zumindest ein Befestigungsabschnitt 13 mit einer Bohrung 12 für ein Verbindungselement 11 ist in einem Bereich zwischen zwei benachbarten Leistungsmodulen 1 vorgesehen. Damit kann die Anpresswirkung gleichmässig auf die Leistungsmodule 1 übertragen werden. Bei Ausgestaltung der Leistungsmodule 1 mit den Ausnehmungen 7 oder Durchgangsöffnungen für die Verbindungselemente 11 können die Formkörper 2 sehr eng aneinander liegend positioniert werden.

Zumindest die mit dem Leistungsmodul 1 in Kontakt kommenden Randbereiche 9, 10 des Anpresselementes 5 könnten auf das Leistungsmodul 1 hin gekrümmt sein, um dadurch bei Bedarf die Anpresskraft zu steigern. Typischerweise ist aber das Anpresselement 5 komplett flach und weist, wenn überhaupt, nur nach dem Verspannen mit der Tragstruktur eine Krümmung in Form einer Durchbiegung auf den Formkörper 2 des Leistungsmoduls 1 hin auf. Um diese Durchbiegung aber zu begrenzen und damit auch die maximale Anpresskraft zu begrenzen und das Anpresselement 5 vom Formkörper 2 möglichst beabstandet zu halten, kann die zentrale Erhebung 6 am Formkörper 2 als Abstandselement und/oder Anschlagselement genutzt werden, wie in Fig. 4 ersichtlich ist.

Anstelle der zungen- oder laschenförmigen Abschnitte 9, 10 des Anpresselementes 5 können gemäss einer anderen erfindungsgemässen Ausführungsform die am Anpresselement 5 ausgeformten Abschnitte als sich entlang eines Randbereiches des Leistungsmoduls 1, vorzugsweise einem Randbereich mit Kontaktpins 3, erstreckenden Randstreifen ausgebildet sein. Vorzugsweise liegen diese Randstreifen an zwei gegenüberliegenden Seiten des Anpresselementes 5 und damit auch des Leistungsmoduls 1.

### Bezugszeichenliste

- 1: Leistungsmodul
- 2: Formkörper
- 2a: Kontaktfläche
- 3: Kontaktpins
- 4: Aufnahme
- 5: Anpresselement
- 6: Zentrale Erhebung
- 7: Ausnehmung
- 8: Zentraler Bereich
- 9: Äusserer Abschnitt
- 10: Äusserer Randbereich
- 11: Verbindungselement
- 12: Bohrung
- 13: Befestigungsabschnitt

## Patentansprüche

1. Anpresselement (5) geeignet für ein Leistungsmodul (1), das Leistungsmodul (1) bestehend aus einem Formkörper (2) mit einer im Wesentlichen ebenen Anlagefläche (2a) zur Anlage an eine Tragstruktur und einer Mehrzahl von aus dem Formkörper (2) herausragenden Kontaktpins (3), wobei das Anpresselement (5) den Formkörper (2) des Leistungsmoduls (1) übergreifen kann, wobei das Anpresselement (5) auf einer der Anlagefläche (2a) gegenüberliegenden Seite des Leistungsmoduls (1) vorsehbar ist und mit zumindest einem Verbindungselement (11) an der Tragstruktur des Leistungsmoduls (1) befestigbar und auch mit einer Anpresskraft auf die Anlagefläche (2a) hin beaufschlagbar ist,
**dadurch gekennzeichnet, dass** pro Leistungsmodul (1) vier äussere Abschnitte (9) zungen- oder laschenförmig von einem zentralen Bereich (8) des Anpresselementes (5) ausgehen, deren äussere Randbereiche (10) in befestigter Stellung von Leistungsmodul (1) und Anpresselement (5) elastisch auf Randbereiche des Leistungsmoduls (1) einwirken können, wobei die am Anpresselement (5) ausgeformten äusseren Abschnitte (9) als sich entlang eines Randbereichs des Leistungsmoduls (1) mit Kontaktpins (3) erstreckenden Randstreifen an zwei gegenüberliegenden Seiten des Anpresselements (5) ausgebildet sind.

2. Anpresselement nach Anspruch 1, **dadurch gekennzeichnet, dass** Befestigungsabschnitte (13) als das Leistungsmodul (1) überragende Laschen mit Bohrungen (12) zur Aufnahme von Verbindungselementen (11), vorzugsweise Schrauben, am Anpresselement (5) ausgebildet sind.

3. Anpresselement nach einem der Ansprüche 1 bis 2, **dadurch gekennzeichnet, dass** zumindest die mit dem Leistungsmodul (1) in Kontakt kommenden Abschnitte (9, 10) auf das Leistungsmodul (1) hin gekrümmt sind.

4. Anpresselement nach einem der Ansprüche 1 bis 3, **dadurch gekennzeichnet, dass** das Anpresselement (5a) eine Länge aufweist um mehrere Leistungsmodule (1) zu übergreifen, wobei zumindest ein Befestigungsabschnitt (13) für zumindest ein Verbindungselement (11) in einem Bereich des Anpresselementes (5) zwischen zwei benachbarten Leistungsmodulen (1) ausgebildet ist.

5. Befestigungssystem für ein Leistungsmodul (1), bestehend aus einem Formkörper (2) mit einer im Wesentlichen ebenen Anlagefläche (2a) zur Anlage an eine Tragstruktur und einer Mehrzahl von aus dem Formkörper (2) herausragenden Kontaktpins (3), mit einem den Formkörper (2) übergreifenden Anpresselement (5) für das Leistungsmodul (1), das auf einer der Anlagefläche (2a) gegenüberliegenden Seite des Leistungsmoduls (1) vorgesehen ist, und mit zumindest einem Verbindungselement (11) zur Befestigung des Anpresselementes (5) an der Tragstruktur und zur Beaufschlagung des Anpresselementes (5) mit einer Anpresskraft auf die Anlagefläche (2a) hin, **dadurch gekennzeichnet, dass** das Anpresselement (5) gemäss einem der Ansprüche 1 bis 4 ausgebildet ist, wobei die Abschnitte (9) und deren äussere Randbereiche (10) in befestigter Stellung von Leistungsmodul (1) und Anpresselement (5) elastisch auf Randbereiche des Leistungsmoduls (1) einwirken und diese Randbereiche mit einer Anpresskraft beaufschlagen.

6. Befestigungssystem nach Anspruch 5, **dadurch gekennzeichnet, dass** Befestigungsabschnitte (13) für je zumindest ein Verbindungselement (11) an zwei gegenüberliegenden Randbereichen des Anpresselementes (5) vorgesehen sind, die in befestigter Stellung von Leistungsmodul (1) und Anpresselement (5) im Bereich eines kontaktpinfreien Randbereiches des Leistungsmoduls (1) zu liegen kommen.

## Claims

1. A contact pressure element (5) suitable for a power module (1), the power module (1) consists of a molded body (2) having a substantially flat contact surface (2a) for contact on a support structure and having a plurality of contact pins (3) projecting from the molded body (2), wherein the contact pressure element (5) can engage over the molded body (2) of the power module (1), wherein the contact pressure element (5) can be provided on a side of the power module (1) opposite the contact surface (2a), can be fastened to the support structure of the power module (1) using at least one connecting element (11), and a contact force can be applied onto the contact surface (2a),
**characterized in that**, per power module (1), four outer sections (9) shaped like tabs or tongues extend from a center area (8) of the contact pressure element (5), the outer edge areas (10) of said outer sections can elastically act on edge areas of the power module (1) in the fastened position of the power module (1) and contact pressure element (5), wherein the outer sections (9) shaped on the contact pressure element (5) are designed as edge strips on two opposite sides of the contact pressure element (5) and extend along an edge area of the power module (1) with contact pins (3) .

2. The contact pressure element according to claim 1, **characterized in that** fastening sections (13) are designed as tabs with bore holes (12) projecting past the power module (1) for receiving connecting elements (11) preferably screws, on the contact pressure element (5) .

3. The contact pressure element according to one of claims 1 to 2, **characterized in that** at least the sections (9, 10) coming into contact with the power module (1) are curved toward the power module (1).

4. The contact pressure element according to one of claim 1 to 3, **characterized in that** the contact pressure element (5a) has a length to engage over a plurality of power modules (1), wherein at least one fastening section (13) for at least one connecting element (11) is designed in an area of the contact pressure element (5) between two adjacent power modules (1).

5. A fastening system for a power module (1), consisting of a molded body (2) having a substantially flat contact surface (2a) for contact on a support structure and having a plurality of contact pins (3) projecting from the molded body (2), having a contact pressure element (5) for the power module (1) which engages over the molded body (2) and is provided on a side of the power module (1) opposite the contact surface (2a), and having at least one connecting element (11) for fastening the contact pressure element (5) to the support structure and for applying the contact pressure element (5) onto the contact surface (2a) with a contact pressure, **characterized in that** the contact pressure element (5) is designed according to one of claims 1 to 4, wherein the sections (9) and their outer edge areas (10) elastically act on edge areas of the power module (1) in the fastened position of the power module (1) and the contact pressure element (5), and apply a contact force on these edge areas.

6. The fastening system according to claim 5, **characterized in that** the fastening sections (13) for in each case at least one connecting element (11) are provided on two opposite edge areas of the contact pressure element (5) and, in the fastening position of the power module (1) and the contact pressure element (5), contact in the area of an edge area of the power module (1) free of contact pins.

## Revendications

1. Élément de pression (5) adapté pour un module de puissance (1), le module de puissance (1) consistant dans un corps moulé (2) pourvu d'une surface d'appui (2a) sensiblement plane, destinée à s'appuyer sur une structure porteuse et dans une multiplicité de broches de contact (3) saillant hors du corps moulé (2), l'élément de pression (5) étant apte à venir en prise sur le corps moulé (2) du module de puissance (1), l'élément de pression (5) pouvant être prévu sur la face du module de puissance (1) qui est opposée à la surface d'appui (2a) et pouvant se fixer sur la structure porteuse du module de puissance (1) à l'aide d'au moins un élément de liaison (11) et pouvant également être soumis à une force de pression en direction de la surface d'appui (2a),
**caractérisé en ce que** par module de puissance (1), quatre segments (9) extérieurs dont les zones marginales (10) extérieures peuvent agir de manière élastique sur des zones marginales du module de puissance (1), lorsque le module de puissance (1) et l'élément de pression (5) se trouvent en position fixée partent en forme de languettes ou de pattes d'une zone centrale (8) de l'élément de pression (5), les segments extérieurs (9) formés sur l'élément de pression (5) étant conçus sous la forme de bandes marginales s'étendant le long d'une zone marginale du module de puissance (1) avec des broches de contact (3) sur deux faces opposées de l'élément de pression (5) .

2. Élément de pression selon la revendication 1, **caractérisé en ce que** des segments de fixation (13) sont conçus sur l'élément de pression (5) sous la forme de pattes saillant par-dessus le module de puissance (1), pourvues de perçages (12) destinés à recevoir des éléments de liaison (11), de préférence des vis.

3. Élément de pression selon l'une quelconque des revendications 1 à 2, **caractérisé en ce qu'**au moins les segments (9, 10) qui viennent en contact avec le module de puissance (1) sont recourbés en direction du module de puissance (1).

4. Élément de pression selon l'une quelconque des revendications 1 à 3, **caractérisé en ce que** l'élément de pression (5a) présente une longueur permettant de venir en prise sur plusieurs modules de puissance (1), au moins un segment de liaison (13) pour au moins un élément de liaison (11) étant conçu dans une zone de l'élément de pression (5) entre deux modules de puissance (1) voisins.

5. Système de fixation destiné à un module de puissance (1), consistant dans un corps moulé (2) pourvu d'une surface d'appui (2a) sensiblement plane, destinée à s'appuyer sur une structure porteuse et dans une multiplicité de broches de contact (3) saillant hors du corps moulé (2), avec un élément de pression (5) pour le module de puissance (1), qui vient en prise sur le corps moulé (2) qui est prévu sur une face du module de puissance (1) qui est opposée à la surface d'appui (2a), et avec au moins un élément de liaison (11), destiné à fixer l'élément de pression (5) avec une force de pression en direction de la surface d'appui (2a), **caractérisé en ce que** l'élément de pression (5) est conçu selon l'une quelconque des revendications 1 à 4, les segments (9) et leurs zones marginales (10) extérieures agissant de manière élastique sur des zones margines du module de puissance (1) et soumettant lesdites zones marginales à une force de pression, lorsque le module de puissance (1) et l'élément de pression (5) se trouvent en position fixée.

6. Système de fixation selon la revendication 5, **caractérisé en ce que** des segments de liaison (13) pour chaque fois au moins un élément de liaison (11) sont prévus sur deux zones marginales opposées de l'élément de pression (5) qui viennent se placer dans la zone d'une zone marginale exempte de broches de contact du module de puissance (1), lorsque le module de puissance (1) et l'élément de pression (5) se trouvent en position fixée.
